# EUROPÄISCHE PATENTSCHRIFT

(11) **EP 3 126 181 B1**
(45) Veröffentlichungstag und Bekanntmachung des Hinweises auf die Patenterteilung: **10.04.2019**
(21) Anmeldenummer: 15702637.8
(22) Anmeldetag: 05.02.2015
(51) Int. Cl.: B60L 3/00, G01R 31/36, G01R 27/08, G01R 31/00, G01R 31/02, G01R 31/04

(54) **VERFAHREN ZUR ÜBERPRÜFUNG EINER VERBINDUNG ZWISCHEN EINEM NIEDRIGSPANNUNGSNETZ UND EINER BATTERIE UND KRAFTFAHRZEUG**
METHOD FOR CHECKING A CONNECTION BETWEEN A LOW-VOLTAGE SUPPLY SYSTEM AND A BATTERY, AND MOTOR VEHICLE
PROCÉDÉ DE CONTRÔLE D'UNE CONNEXION ENTRE UN RÉSEAU BASSE TENSION ET UNE BATTERIE, ET VÉHICULE AUTOMOBILE

(30) Priorität: 02.04.2014 DE 102014004791
(43) Veröffentlichungstag der Anmeldung: 08.02.2017
(73) Patentinhaber: Audi AG, 85045 Ingolstadt (DE)
(72) Erfinder: BARTH, Karsten, 09120 Chemnitz (DE); NAUMANN, Rolf, 96247 Michelau (DE); HACKNER, Thomas, 91171 Greding (DE)
(74) Vertreter: Herbst, Matthias Heinz
(86) Internationale Anmeldenummer: PCT/EP2015/000224
(87) Internationale Veröffentlichungsnummer: WO 2015/149896

(56) Entgegenhaltungen:
- DE-A1- 10 219 824
- DE-A1-102011 087 678
- DE-A1-102012 215 755
- FR-A1- 2 965 409

## Beschreibung

Die Erfindung betrifft ein Verfahren zur Überprüfung einer Verbindung zwischen einer ein Niedrigspannungsnetz eines Kraftfahrzeugs, dessen Spannung niedriger ist als die Spannung eines Hochspannungsnetzes des Kraftfahrzeugs, versorgenden Batterie und dem Niedrigspannungsnetz, wobei ein Gleichspannungswandler, der zum Austausch elektrischer Energie zwischen dem Hochspannungsnetz und dem Niedrigspannungsnetz ausgebildet ist, das Hochspannungsnetz mit dem Niedrigspannungsnetz verbindet. Daneben betrifft die Erfindung ein Kraftfahrzeug.

Moderne Kraftfahrzeuge weisen üblicherweise ein Bordnetz auf, welches durch eine Batterie gespeist wird. Die Spannungslage eines derartigen, bekannten Bordnetzes liegt üblicherweise bei etwa 12 V. In letzter Zeit haben sich jedoch eine Vielzahl von Anwendungen ergeben, bei denen Verbraucher, die bei höheren Spannungen arbeiten, vorgesehen sind, insbesondere bei der Verwendung von Elektromotoren als alleiniges oder zusätzliches Antriebsmittel des Kraftfahrzeugs. In diesem Fall werden üblicherweise zwei elektrische Netze in dem Kraftfahrzeug vorgesehen, nämlich ein Niedrigspannungsnetz, welches meist auf der bisher üblichen Spannung von 12 V liegt, und ein Hochspannungsnetz, dessen Spannung höher ist als die des Niedrigspannungsnetzes. Die Spannung des Hochspannungsnetzes kann beispielsweise bei Werten oberhalb von 48 V liegen. Das Hochspannungsnetz und das Niedrigspannungsnetz werden oft durch einen Gleichspannungswandler (DC/DC-Wandler) verbunden, um den Energieaustausch zwischen beiden Netzen zu ermöglichen, beispielsweise also die Batterie des Niedrigspannungsnetzes über das Hochspannungsnetz zu laden, beispielsweise wenn ein Generator an das Hochspannungsnetz angeschlossen ist, oder um das Hochspannungsnetz kurzzeitig mit Energie aus dem Niedrigspannungsnetz zu stützen. Zudem ist es auch bekannt, die Versorgung leistungsintensiver Verbraucher des Niedrigspannungsnetzes mit über das Hochspannungsnetz zu erledigen.

Ein Fehler, der in dem Niedrigspannungsnetz auftreten kann, ist ein Verlust der Verbindung zwischen dem Niedrigspannungsnetz und der es versorgenden Batterie. Derartiges kann beispielsweise durch Kabelbruch und dergleichen zu Stande kommen. Ein derartiger Fehler ist für den Fahrer nicht unmittelbar spürbar, wenn ein Generator mittelbar oder unmittelbar die elektrische Energie liefert, die zum Betrieb der Verbraucher der Niedrigspannungsnetzes benötigt wird. Daher wird durch Steuergeräte in Kraftfahrzeugen häufig eine sogenannte Batterie-Ab-Erkennung durchgeführt, welche die Verbindung zwischen dem Niedrigspannungsnetz und der Batterie überprüfen soll. Dabei ist es üblich, den Strom und die Spannung an der Batterie zu vermessen, um hieraus den Widerstand zu ermitteln. Dieser kann nun gegen verschiedene Verbindungskriterien geprüft werden, meist dahingehend, ob der Widerstand einen Schwellwert, beispielsweise 30 mOhm, unterschreitet und/oder ob er nicht zu starken Schwankungen unterliegt, mithin im Wesentlichen stabil bleibt. Derartige Messmethoden sind im Stand der Technik bereits grundsätzlich bekannt.

In herkömmlichen Kraftfahrzeugen ist häufig ein Klauenpolgenerator vorgesehen, der eine große Strom- und Spannungswelligkeit im 12V-Bordnetz, also dem Niedrigspannungsnetz, erzeugt. Dies ist wichtig, da der der Batterie zugeordnete Stromsensor häufig nicht exakt 0 A messen kann bzw. im Bereich kleiner Ströme die größten Unsicherheiten aufweist. Grund hierfür kann beispielsweise ein relativ großer Offset-Wert des Stromsensors sein. Dabei ist ferner zu beachten, dass selbst bei abgeklemmter Batterie bzw. anderweitig unterbrochener Verbindung zum Niedrigspannungsnetz der Stromsensor noch einen Stromfluss anzeigen kann, bedingt durch von Spannungsschwankungen verursachte Störeinstrahlungen. Ist nun beispielsweise die Batterie voll geladen und wird das Niedrigspannungsnetz aus anderer Quelle, beispielsweise einem Generator oder dem Gleichspannungswandler, versorgt, ist der vorliegende Batterie-Gleichstrom 0 A. Bei einem solchen Zustand wäre mithin keine verlässliche Messung und keine verlässliche Batterie-Ab-Erkennung möglich.

Bei Kraftfahrzeugen mit einem Klauenpolgenerator, der unmittelbar an das Niedrigspannungsnetz angeschlossen ist, ist dies unproblematisch, da die beschriebene große Strom- und Spannungswelligkeit gegeben ist, die zwangsläufig größere Ströme in die Batterie einprägt. In Kraftfahrzeugen, in denen der Generator allenfalls über den Gleichspannungswandler angebunden ist, ist die beschriebene Strom- und Spannungswelligkeit im Bordnetz nicht mehr vorhanden, da der Gleichspannungswandler die Verbraucher des Niedrigspannungsnetzes hochdynamisch versorgt. Hierdurch wird die Batterie, beispielsweise eine 12V-Bleibatterie, nicht mehr belastet. Mithin stößt die bisherige Methode zur Batterie-Ab-Erkennung an Grenzen.

Doch auch im Fall einer Anregung durch den Generator treten Probleme auf, da die Diagnose der Verbindung der Batterie zu dem Niedrigspannungsnetz nicht deterministisch ist. Sie ist abhängig von den Komponenten des Niedrigspannungsnetzes und deren Leistungsaufnahme bzw. -abgabe. Zusätzlich hat die Verkabelung einen Einfluss auf die Stromwelligkeit. Gerade im Hinblick darauf, dass die Anforderungen an die Robustheit und Sicherheit der Überprüfung der Verbindung zwischen der Batterie und dem Niedrigspannungsnetz zunehmen, da immer mehr sicherheitsrelevante Verbraucher aus dem Niedrigspannungsnetz versorgt werden müssen, ist die aktuelle Umsetzung der Batterie-Ab-Erkennung als verbesserungswürdig anzusehen.

DE 10 2011 087 678 A1 offenbart eine Vorrichtung zur Erfassung des Zustands eines zu prüfenden Akkumulators eines Fahrzeugs mit mindestens zwei Fahrzeugbordnetzen unterschiedlicher Betriebsspannungen, aufweisend einen DC/DC-Wandler, der eine erste Gleichspannung eines ersten Fahrzeugbordnetzes in eine zweite Gleichspannung des Akkumulators des zweiten Fahrzeugbordnetzes wandelt, und eine Steuereinrichtung der Fahrzeugbordnetze. Diese umfasst ein Testsignalmodul, das geeignet ist, ein Testsignal über den DC/DC-Wandler an den zu prüfenden Akkumulator anzulegen, ein Messwerterfassungsmodul, das geeignet ist, die Reaktionswerte des zu prüfenden Akkumulators zu messen und ein Auswertemodul, das geeignet ist, aus den gemessenen Reaktionswerten den Zustand des Akkumulators zu erfassen.

DE 102 19 824 A1 offenbart ein Verfahren zur Erkennung eines batterielosen Betriebs eines Fahrzeugbordnetzes, das wenigstens einen von einem Motor angetriebenen Generator, eine Batterie sowie mit der Batterie verbindbare Verbraucher und Mittel zur Spannungsauswertung umfasst, wobei die Generatorspannung und die Batteriespannung gemessen und die ermittelten Spannungswerte zueinander in Bezug gesetzt werden und aus den daraus erhaltenen Ergebnissen auf eine Fehlfunktion der Batterie oder eine Unterbrechung zwischen der Batterie und dem Bordnetz und somit auf einen batterielosen Betrieb erkannt wird.

FR 2 965 409 A1 offenbart ein Verfahren zur Bestimmung des Alterungszustandes eines elektrochemischen Speichersystems mit einer ersten elektrochemischen Speicherquelle, einer zweiten elektrochemischen Speicherquelle und einem DC/DC-Wandler zum Umwandeln elektrischer Energie zwischen der ersten und der zweiten Speicherquelle, wobei der DC/DC-Wandler ein vorgegebenes Spannungssignal bzw. Stromsignal auf mindestens eine aus der ersten und zweiten ausgewählten Speicherquelle anwendet, eine aus der Anwendung des vorgegebenen Signals resultierende Abweichung des Stroms bzw. der Spannung der ausgewählten Speicherquelle gemessen wird, in Abhängigkeit des vorgegebenen Signals und der gemessenen Abweichung ein Wert, der repräsentativ für den aktuellen Innenwiderstand, eine aktuelle innere Impedanz und/oder eine aktuelle innere Kapazität der ausgewählten Speicherquelle ist, bestimmt wird, und ein Parameter, der einen Grad der Alterung der ausgewählten Speicherquelle darstellt, in Abhängigkeit des Wertes bestimmt wird.

DE 10 2012 215 755 A1 offenbart einen Gleichspannungswandler, welcher dazu ausgelegt ist, ein eine Niedervoltbatterie und eine Batteriesensorschaltung umfassendes Niedervoltnetz mit einer Niedervoltspannung zu versorgen, umfassend eine Pulserzeugungseinrichtung, welche dazu ausgelegt ist, elektrische Pulse zum Testen der Niedervoltbatterie durch die Batteriesensorschaltung in das Niedervoltnetz einzuspeisen.

Der Erfindung liegt daher die Aufgabe zugrunde, ein robustes, deterministisches Verfahren zur Überprüfung einer Verbindung zwischen einer Batterie und einem Niedrigspannungsnetz anzugeben.

Zur Lösung dieser Aufgabe ist erfindungsgemäß ein Verfahren gemäß Anspruch 1 vorgesehen.

Der Erfindung liegt die Erkenntnis zugrunde, dass üblicherweise aktiv ansteuerbare Gleichspannungswandler verwendet werden, welche mithin eingesetzt werden können, um gezielt einen definierten Strom in die Batterie einzuprägen oder aus der Batterie zu entnehmen. Mithin ist es möglich, den Batteriestrom durch Modulation der Ausgangsfrequenz des Gleichspannungswandlers mit einer oder mehreren definierten Modulationsfrequenzen zu verändern, um dann mittels eines an der Batterie vorgesehenen Stromsensors und Spannungssensors die Reaktion der Batterie auf diese künstliche, gezielt vorgenommene Anregung zu vermessen. Mit anderen Worten wird der Gleichspannungswandler genutzt, um gezielt einen messrelevanten Strom in die Batterie einzuprägen, der durch den batterieseitigen Stromsensor hinreichend verlässlich gemessen werden kann. Auf diese Weise ist eine deterministische und damit zuverlässigere Diagnose gegeben, die nicht von den Verbrauchern des Niedrigspannungsnetzes abhängig ist. Die Erfindung ermöglicht es zudem, eine Batterie-Ab-Erkennung gemäß einem Sicherheitsstandard zu entwickeln, beispielsweise ASIL-relevant, so dass sicherheitsrelevante Verbraucher aus der Batterie versorgt werden können.

Wie bereits erwähnt, ist die aktive Anregung durch den Gleichspannungswandler deswegen notwendig, da es mit dem Stromsensor der Batterie technisch nicht möglich ist, exakt 0 A zu messen. Die Strommessung durch den Stromsensor ist üblicherweise für einen sehr großen Strombereich ausgelegt, beispielsweise für Ströme von -1500 bis +1500 A. Dadurch ist eine Messung von sehr kleinen Strömen mit einer großen Messungenauigkeit belastet. Die aktive Anregung durch den Gleichspannungswandler erlaubt es nun, hinreichend große Ströme in die Batterie einzuprägen, um eine verlässliche Messung zu erlauben.

In konkreter Ausgestaltung der vorliegenden Erfindung kann vorgesehen sein, dass als Verbindungskriterium überprüft wird, ob der Widerstand unterhalb eines Widerstandsschwellwertes, insbesondere im Bereich von 25 bis 50 mOhm, liegt und/oder ob ein aus dem zeitlichen Verlauf des Widerstands abgeleiteter Schwankungswert unterhalb eines Schwankungsschwellwerts liegt. Beispielsweise kann ein Widerstandsschwellwert von 30 mOhm verwendet werden, das bedeutet, es wird überprüft, ob der Widerstand in einem Bereich von 0 bis 30 mOhm liegt. Zudem sollte der Widerstand dann, wenn sich die Batterie am Niedrigspannungsnetz befindet, einigermaßen konstant sein, was durch einen Schwankungsschwellwert beschrieben werden kann, beispielsweise eine Standardabweichung oder dergleichen. Ist der aus den Messwerten ermittelte Widerstand größer als 30 mOhm und eine starke Schwankung des Widerstandswerts gegeben, besteht keine Verbindung zwischen der Batterie und dem Niedrigspannungsnetz ("Batterie ab").

Es kann vorgesehen sein, dass mehrere Modulationsfrequenzen gleichzeitig und/oder in zeitlicher Abfolge verwendet werden und/oder die Modulation sinusförmig erfolgt. Durch Überlagerung mehrerer sinusförmiger Schwingungen lassen sich letztlich beliebige Stromverläufe in die Batterie induzieren, solange dies zweckmäßig ist. Es hat sich jedoch gezeigt, dass ein zur Messung idealer Frequenzbereich für die meisten Messanordnungen von Stromsensor und Spannungssensor besteht, mithin sinusförmige Anregungen eines Batteriestroms besonders zweckmäßig sein können.

Insbesondere hat sich in diesem Zusammenhang gezeigt, dass es besonders vorteilhaft ist, wenn die Modulationsfrequenz in einem Frequenzband von 50 bis 200 Hz gewählt wird, wobei grundsätzlich jedoch auch andere Frequenzen bis hin in den niedrigen kHz-Bereich denkbar sind. Durch den Gleichspannungswandler kann ein Strom genau in diesem Frequenzband eingeprägt werden. Auf diese Weise kann im Übrigen auch die Amplitude der Stromwelligkeit reduziert werden, was den Einfluss auf das Niedrigspannungsnetz reduziert. Beispielsweise kann vorgesehen sein, dass die Amplitude der Modulation kleiner als 10 % der Absolutspannung des Gleichspannungswandlers ist.

Wie bereits erwähnt, wird in konventionellen Bordnetzen die Stromwelligkeit durch den Klauenpolgenerator erzeugt. Da die Frequenz der Stromwelligkeit abhängig von der Motordrehzahl ist, existierten Arbeitspunkte, in denen die Batterie-Ab-Erkennung des Standes der Technik besser funktionierte als in anderen Arbeitspunkten. Mittels des erfindungsgemäßen Vorgehens ist es nun möglich, Frequenzbänder bzw. Frequenzen zu wählen, in denen bereits ein idealer Arbeitspunkt zur Bestimmung des Widerstandes gegeben ist, weshalb auch eine niedrigere Amplitude ausreichend ist, um eine zuverlässige Messung zu ermöglichen. Zudem können bestimmte Frequenzen auch zur Folge haben, dass nicht mehr der reine Realteil des Batteriewiderstandes gemessen wird, welche Frequenzen beispielsweise in der nicht zwangsläufig sinusförmigen Anregung durch einen Klauenpolgenerator enthalten waren. Mithin konnte es auch diesbezüglich zu Messfehlern kommen, die durch das erfindungsgemäße Verfahren vermieden werden können, insbesondere, wenn eine sinusförmige Modulation verwendet wird und die Modulationsfrequenz geschickt gewählt wird, insbesondere im genannten Bereich von 50 bis 200 Hz.

An dieser Stelle sei im Übrigen noch angemerkt, dass der Gleichspannungsanteil der Ausgangsspannung des Gleichspannungswandlers bei einer Anregung mit der Modulationsfrequenz in Abhängigkeit des Ladezustands der Batterie gewählt werden kann. Häufig schwankt die Spannung der Batterie mit dem Ladezustand zumindest leicht, so dass die Spannungslage abhängig vom Ladezustand der Batterie so gewählt werden kann, dass mit Sicherheit ein nützlicher, messbarer Strom in die Batterie eingeprägt wird. Methoden zur Messung des Ladezustands einer Batterie sind im Stand der Technik bereits bekannt und können auch im Rahmen der vorliegenden Erfindung eingesetzt werden. Die Modulation der Ausgangsspannung des Gleichspannungswandlers bewirkt dann entweder, dass die Batterie geladen wird, entladen wird, oder dass der Strommittelwert gleichbleibt. Dabei sei darauf hingewiesen, dass die Grundlast in einem Kraftfahrzeug meist mindestens 10 A beträgt, das bedeutet, es ist auch bei voller Batterie möglich, die Batterie mit mindestens 10 A zu entladen.

Eine weitere Größe neben dem Ladezustand der Batterie, die die Amplitude der Ausgangsspannung des Gleichspannungswandlers beeinflussen kann, ist im Übrigen die Impedanz des Niedrigspannungsnetzes. Üblicherweise wird, allgemein gesagt, die Ausgangsspannung des Gleichspannungswandlers vergleichbar oder niedriger als die eines Klauenpolgenerators in konventionellen Kraftfahrzeugen sein. Wie bereits erwähnt wurde, kann die Amplitude der Modulation selbst beispielsweise im Bereich von 10 % oder weniger des Gleichspannungsanteils der Ausgangsspannung sein, so dass beispielsweise eine Spannungsvariation zwischen 12,6 und 15 V möglich ist.

Die Überprüfung kann zyklisch oder kontinuierlich erfolgen oder aufgrund eines Triggerereignisses ausgelöst werden. Es ist mithin möglich, die Verbindung der Batterie zu dem Niedrigspannungsnetz zyklisch, also in festen Zeitabständen, zu überprüfen. Zweckmäßig kann es jedoch auch sein, beispielsweise durch ständiges Vorhandensein der Anregung, eine kontinuierliche Überprüfung stattfinden zu lassen. Um die Netzbelastung jedoch möglichst gering zu halten, ist es zweckmäßig, die Überprüfung aufgrund eines Triggerereignisses auszulösen, was beispielsweise ausgehend von einem für das Energiemanagement zuständigen Steuergerät im Kraftfahrzeug geschehen kann.

Dabei kann als Triggerereignis ein Starten des Kraftfahrzeugs und/oder die Detektion einer kritischen Betriebssituation des Niedrigspannungsnetzes verwendet werden. Davon können auch Start/Stopp-Vorgänge umfasst sein, wenn ein eine Start/Stopp-Funktion realisierendes Fahrzeugsystem vorhanden ist. Besonders zweckmäßig ist es jedoch, kritische Betriebssituationen des Niedrigspannungsnetzes, insbesondere kritische Fahrsituationen, als Trigger für eine Überprüfung der Verbindung zwischen Batterie und Niedrigspannungsnetz vorzusehen. Dabei kann insbesondere vorgesehen sein, dass eine kritische Betriebssituation wenigstens dann detektiert wird, wenn wenigstens ein vorbestimmter, insbesondere sicherheitsrelevanter Verbraucher nicht mehr allein durch den Gleichspannungswandler aus dem Hochspannungsnetz versorgt werden könnte. Benötigt beispielsweise die Heizung des Kraftfahrzeugs eine hohe elektrische Energiemenge aus dem Gleichspannungswandler, wird aber auch elektrische Energie für eine Lenkung des Kraftfahrzeugs benötigt, liegt ein kritischer Fahrzeugzustand vor, da die Batterie elektrische Energie beisteuern muss.

Zweckmäßigerweise kann bei einer festgestellten Verbindungsstörung eine entsprechende Information an den Fahrer des Kraftfahrzeugs ausgegeben werden. Nachdem durch das erfindungsgemäße Verfahren eine höhere Zuverlässigkeit der Batterie-Ab-Erkennung gegeben ist, existiert nun die Möglichkeit, eine Verbindungsstörung unmittelbar dem Fahrer anzuzeigen, da das Risiko für einen Fehlalarm deutlich reduziert ist.

Eine vorteilhafte Weiterbildung der vorliegenden Erfindung sieht vor, dass auch an dem Gleichspannungswandler eine Widerstandsmessung durchgeführt wird und dessen Verbindung zu dem Niedrigspannungsnetz überprüft wird. Auf diese Weise ist auch feststellbar, ob der Gleichspannungswandler weiterhin mit dem Niedrigspannungsnetz verbunden ist, nachdem durch den in der Batterie entstehenden Strom selbstverständlich auch ein entsprechender Strom am Gleichspannungswandler entstehen muss. Auf diese Weise kann mithin überprüft werden, ob die aktive Anregung durch den Gleichspannungswandler die Batterie überhaupt erreicht.

Besonders vorteilhaft ist es zudem, wenn das erfindungsgemäße Verfahren unter Berücksichtigung wenigstens eines Sicherheitsstandards, insbesondere des ASIL-Standards (ISO 26262), entwickelt wird. Insbesondere kann also wenigstens ein zur Durchführung des erfindungsgemäßen Verfahrens verwendetes Computerprogramm wenigstens einem Sicherheitsstandard, insbesondere dem ASIL-Standard, genügen.

Die vorgenannte Aufgabe wird ferner erfindungsgemäß gelöst durch ein Kraftfahrzeug gemäß Anspruch 10. Dabei ist es durchaus denkbar, dass die Funktionen des erfindungsgemäßen Verfahrens auf zwei oder mehr Steuergeräte aufgeteilt werden, wobei auch die Verwendung eines zentralen Energiemanagement-Steuergeräts zweckmäßig sein kann. Sämtliche Ausführungen bezüglich des erfindungsgemäßen Verfahrens lassen sich analog auf das erfindungsgemäße Kraftfahrzeug übertragen, so dass auch mit diesem die bereits genannten Vorteile erhalten werden können.

In konkreter Ausgestaltung können beispielsweise ein Energiemanagement-Steuergerät und ein Batteriesteuergerät vorgesehen sein, wobei das Batteriesteuergerät das Auslesen des Stromsensors und des Spannungssensors der Batterie übernimmt und gegen die Verbindungskriterien prüfen kann. Seitens des Energiemanagement-Steuergeräts kann beispielsweise ein Triggersignal empfangen werden, woraufhin dieses den aktiv ansteuerbaren Gleichspannungswandler mit einer bestimmten, gegebenenfalls vom vom Batteriesteuergerät erhaltenen Ladezustand abhängigen gewünschten Spannungsverlauf ansteuert. Seitens des Batteriesteuergeräts, das eine entsprechende Information vom Energiemanagement-Steuergerät erhält, kann die Messung durchgeführt werden und das Ergebnis gegebenenfalls an das Energiemanagement-Steuergerät weitergeleitet werden.

Weitere Vorteile und Einzelheiten der vorliegenden Erfindung ergeben sich aus den im Folgenden beschriebenen Ausführungsbeispielen sowie anhand der Zeichnung. Dabei zeigen:
- Fig. 1: eine Prinzipskizze zur Verschaltung im erfindungsgemäßen Kraftfahrzeug, und
- Fig.2: ein erfindungsgemäßes Kraftfahrzeug.

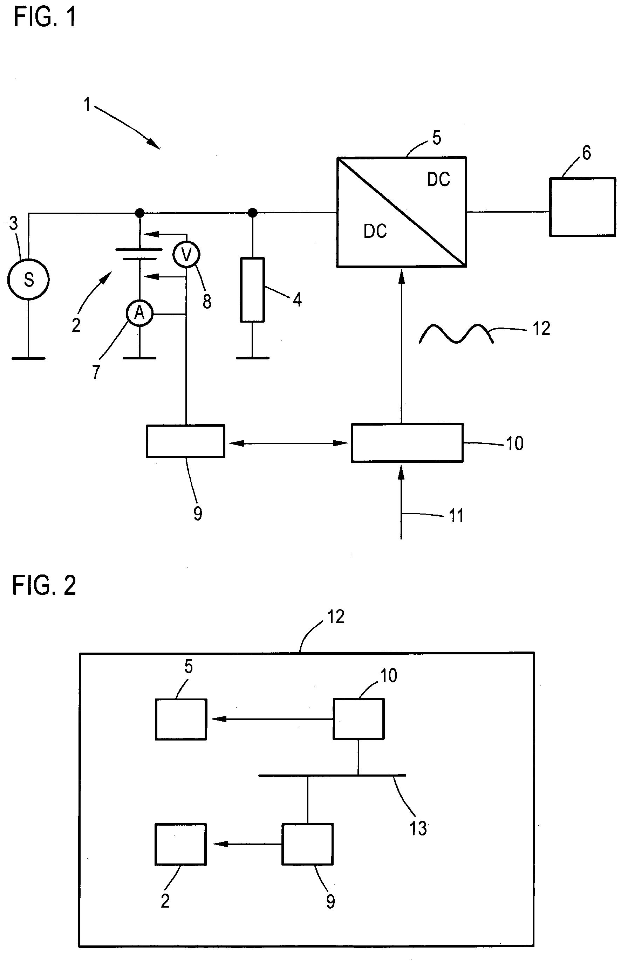

Fig. 1 zeigt in Form einer groben Prinzipskizze die Verschaltungen der Netze in einem erfindungsgemäßen Kraftfahrzeug sowie die im erfindungsgemäßen Verfahren benutzte funktionelle Wechselwirkung. Dabei ist zunächst ein Niedrigspannungsnetz 1 vorgesehen, das vorliegend auf einer Spannung von 12 V liegt. Das Niedrigspannungsnetz 1 wird von einer Batterie 2, hier einer Bleisäure-Batterie, gespeist. Als Verbraucher des Niedrigspannungsnetzes 1 sind ein Starter 3 und ein weiterer Verbraucher 4 schematisch dargestellt.

Über einen Gleichspannungswandler 5 ist das Niedrigspannungsnetz 1 mit einem hier nur schematisch dargestellten Hochspannungsnetz 6 verbunden, dessen Spannung höher ist als die des Niedrigspannungsnetzes. Über den Gleichspannungswandler 5 kann Energie zwischen dem Niedrigspannungsnetz 1 und dem Hochspannungsnetz 6 ausgetauscht werden.

An der Batterie 2 sind ein Stromsensor 7 und ein Spannungssensor 8 vorgesehen, die von einem Batteriesteuergerät 9 ausgelesen werden können. Dabei ist der Stromsensor 7 für die Messung in einem sehr großen Bereich ausgebildet und kann mithin, auch aufgrund eines möglicherweise vorliegenden Offsets, niedrige Ströme im Bereich von 0 A nur äußerst ungenau messen.

Das Batteriesteuergerät 9 ist jedoch dazu ausgebildet, aus dem Strom und der Spannung, wie sie durch die Sensoren 7, 8 gemessen wurden, ein Widerstand zu ermitteln und gegen Verbindungskriterien zu überprüfen, die anzeigen, ob die Batterie 2 auch weiterhin mit dem Niedrigspannungsnetz 1 verbunden ist. Vorliegend wird in deren Rahmen überprüft, ob der Widerstand kleiner als ein Widerstandsschwellwert, hier 30 mOhm, ist und ob ein die Schwankungen des Widerstands über die Zeit beschreibender Schwankungswert kleiner als ein Schwankungsschwellwert ist. Aufgrund der beschriebenen Eigenschaften des Stromsensors 7 ist diese Messung nur verlässlich möglich, wenn ein größerer Strom aus der Batterie oder in die Batterie existiert.

Dieser Strom kann vorliegend gezielt in die Batterie 7 eingeprägt werden, nachdem das Batteriesteuergerät 9 und ein zusätzlich vorgesehenes Energiemanagement-Steuergerät 10 dazu ausgebildet sind, das erfindungsgemäße Verfahren durchzuführen.

Dazu wird vorliegend ein ein Triggerereignis anzeigendes Triggersignal gemäß dem Pfeil 11 an das Energiemanagement-Steuergerät 10 übermittelt. Das Triggerereignis kann ein Starten des Kraftfahrzeugs oder eine kritische Betriebssituation des Niedrigspannungsnetzes 1 anzeigen, beispielsweise, dass ein insbesondere sicherheitsrelevanter Verbraucher 4 des Niedrigspannungsnetzes 1 nicht mehr allein durch den Gleichspannungswandler 5 versorgt werden kann. Bei Eintritt eines derartigen Triggerereignisses soll also überprüft werden, ob zwischen der Batterie 2 und dem Niedrigspannungsnetz 1 noch eine Verbindung besteht (Batterie-Ab-Erkennung). Hierzu steuert das Energiemanagement-Steuergerät 10 den Gleichspannungswandler 5 zur Modulation der Ausgangsspannung des Gleichspannungswandlers 5 an, wobei ein beispielhafter Spannungsverlauf 12 symbolisch gezeigt ist. Die Ausgangsspannung besteht aus einem Gleichspannungsanteil, der in Abhängigkeit des Ladezustands der Batterie 2, die dem Energiemanagement-Steuergerät 10 vom Batteriesteuergerät 9 zur Verfügung gestellt wird, und der Impedanz des Niedrigspannungsnetzes abhhängig ist, sowie einer Modulation dieses Gleichspannungsanteils, welche vorliegend mit einer Frequenz von 100 Hz sinusförmig erfolgt.

Diese Spannungsschwankungen im Niedrigspannungsnetz 1 haben zur Folge, dass in die Batterie 2 ein Strom eingeprägt wird, der entsprechend von dem Stromsensor 7 erfasst werden kann, während gleichzeitig mittels des Spannungssensors 8 die Spannung vermessen wird. Mit anderen Worten wird der Gleichspannungswandler 5 aktiv angesteuert, um einen Strom in die Batterie 2 einzuprägen, der eine verlässliche Messung des Widerstands erlaubt.

Seitens des Batteriesteuergeräts 9 wird sodann überprüft, ob der Widerstand über dem Widerstandsschwellwert liegt und der Schwankungswert oberhalb des Schwankungsschwellwerts. Ist dies der Fall, wird die Batterie 2 als nicht mit dem Niedrigspannungsnetz 1 verbunden erkannt, was dem Energiemanagement-Steuergerät 10 mitgeteilt wird. Dieses kann nun beispielsweise eine Ausgabe dieser Information an den Fahrer und/oder an andere Fahrzeugsystems veranlassen.

Fig. 2 zeigt schließlich noch eine Prinzipskizze eines erfindungsgemäßen Kraftfahrzeugs 12, in dem die Batterie 2 und der Gleichspannungswandler 5 sowie die sonstigen in Fig. 1 gezeigten Komponenten verbaut sind. Das Batteriesteuergerät 9 kann über ein Bussystem 13 mit dem Energiemanagement-Steuergerät 10 und weiteren Fahrzeugsystemen kommunizieren.

Es sei an dieser Stelle noch darauf hingewiesen, dass die Funktionen des Batteriesteuergeräts 9 und des Energiemanagement-Steuergeräts 10 selbstverständlich auch in einem einzigen Steuergerät realisiert werden können. Ferner können die Steuergeräte 9, 10 auch weiteren Aufgaben dienen.

Das Triggersignal muss dem Energiemanagement-Steuergerät 10 nicht zwangsläufig extern zugeführt werden, sondern kann auch durch dieses selbst aufgrund der aktuellen Auslastung der Netze 1, 6 selbst bestimmt werden. Ferner muss die Auslösung der Überprüfung nicht zwangsläufig durch ein Triggerereignis erfolgen, sondern es können auch zyklische Überprüfungen in bestimmten Zeitabständen oder gar eine kontinuierliche Überwachung erfolgen.

## Patentansprüche

1. Verfahren zur Überprüfung einer Verbindung zwischen einer ein Niedrigspannungsnetz (1) eines Kraftfahrzeugs (12), dessen Spannung niedriger ist als die Spannung eines Hochspannungsnetzes (6) des Kraftfahrzeugs (12), versorgenden Batterie (2) und dem Niedrigspannungsnetz (1), wobei ein Gleichspannungswandler (5), der zum Austausch elektrischer Energie zwischen dem Hochspannungsnetz (6) und dem Niedrigspannungsnetz (1) ausgebildet ist, das Hochspannungsnetz (6) mit dem Niedrigspannungsnetz (1) verbindet,
**dadurch gekennzeichnet,**
**dass** seitens des Gleichspannungswandlers (5) eine Modulation der Ausgangsspannung in das Niedrigspannungsnetz mit einer Modulationsfrequenz erfolgt, wobei der hierdurch eingeprägte Strom und die hierdurch eingeprägte Spannung seitens der Batterie (2) gemessen werden und aus der gemessenen Spannung und dem gemessenen Strom ein Widerstandswert bestimmt und bezüglich wenigstens eines Verbindungskriteriums ausgewertet wird, wonach bei wenigstens einem nicht erfüllten Verbindungskriterium eine Verbindungsstörung festgestellt wird.

2. Verfahren nach Anspruch 1,
**dadurch gekennzeichnet,**
**dass** als Verbindungskriterium überprüft wird, ob der Widerstand unterhalb eines Widerstandsschwellwertes, insbesondere im Bereich von 25 bis 50 mOhm, liegt und/oder ob ein aus dem zeitlichen Verlauf des Widerstands abgeleiteter Schwankungswert unterhalb eines Schwankungsschwellwerts liegt.

3. Verfahren nach Anspruch 1 oder 2,
**dadurch gekennzeichnet,**
**dass** mehrere Modulationsfrequenzen gleichzeitig und/oder in zeitlicher Abfolge verwendet werden und/oder die Modulation sinusförmig erfolgt.

4. Verfahren nach einem der vorangehenden Ansprüche,
**dadurch gekennzeichnet,**
**dass** die Modulationsfrequenz in einem Frequenzband von 50 bis 200 Hz gewählt wird und/oder die Amplitude der Modulation kleiner als 10% der Absolutspannung des Gleichspannungsanteils des Gleichspannungswandlers (5) ist und/oder der Gleichspannungsanteil der Ausgangsspannung des Gleichspannungswandlers (5) in Abhängigkeit von dem Ladezustand der Batterie (2) gewählt wird.

5. Verfahren nach einem der vorangehenden Ansprüche,
**dadurch gekennzeichnet,**
**dass** die Überprüfung zyklisch oder kontinuierlich erfolgt oder aufgrund eines Triggerereignisses ausgelöst wird.

6. Verfahren nach Anspruch 5,
**dadurch gekennzeichnet,**
**dass** als Triggerereignis ein Starten des Kraftfahrzeugs (12) und/oder die Detektion einer kritischen Betriebssituation des Niedrigspannungsnetzes (1) verwendet wird.

7. Verfahren nach Anspruch 6,
**dadurch gekennzeichnet,**
**dass** eine kritische Betriebssituation wenigstens dann detektiert wird, wenn wenigstens ein vorbestimmter, insbesondere sicherheitsrelevanter Verbraucher (4) nicht mehr allein durch den Gleichspannungswandler (5) aus dem Hochspannungsnetz (6) versorgt werden könnte.

8. Verfahren nach einem der vorangehenden Ansprüche,
**dadurch gekennzeichnet,**
**dass** bei einer festgestellten Verbindungsstörung eine entsprechende Information an den Fahrer des Kraftfahrzeugs (12) ausgegeben wird.

9. Verfahren nach einem der vorangehenden Ansprüche,
**dadurch gekennzeichnet,**
**dass** auch an dem Gleichspannungswandler (5) eine Widerstandsmessung durchgeführt wird und dessen Verbindung zu dem Niedrigspannungsnetz (1) überprüft wird.

10. Kraftfahrzeug (12), umfassend ein Niedrigspannungsnetz (1), ein Hochspannungsnetz (6), dessen Spannung höher als die des Niedrigspannungsnetzes (1) ist, eine das Niedrigspannungsnetz (1) speisende Batterie (2), einen das Hochspannungsnetz (6) mit dem Niedrigspannungsnetz (1) verbindenden Gleichspannungswandler (5), der zum Austausch elektrischer Energie zwischen dem Hochspannungsnetz (6) und dem Niedrigspannungsnetz (1) ausgebildet ist, und wenigstens ein Steuergerät (9, 10), das zur Durchführung eines Verfahrens nach einem der vorangehenden Ansprüche ausgebildet ist.

## Claims

1. Method for checking a connection between a battery (2) supplying a low-voltage network (1) of a motor vehicle (12), a voltage of which is lower than the voltage of a high-voltage network (6) of the motor vehicle (12), and the low-voltage network (1) wherein a DC voltage converter (5), which is configured for exchanging electrical power between the high-voltage network (6) and the low-voltage network (1), connects the high-voltage network (6) to the low-voltage network (1),
**characterised in that**
the output voltage is modulated via the DC voltage converter (5) into the low-voltage network at a modulation frequency, wherein the current hereby applied and the voltage hereby applied are measured at the battery (2) and a resistance value is determined from the measured voltage and the measured current and evaluated with respect to at least one connection criterion, whereupon a connection fault is determined when at least one connection criterion is not fulfilled.

2. Method according to claim 1,
**characterised in that**,
a check is made as a connection criterion to determine whether the resistance is less than a resistance threshold, in particular in a range from 25 to 50 mOhm and/or whether a fluctuation value derived from the chronological progression of the resistance is less than a fluctuation threshold value.

3. Method according to claim 1 or 2,
**characterised in that**,
a plurality of modulation frequencies is used simultaneously and/or in chronological sequence and/or the modulation is sinusoidal.

4. Method according to any one of the preceding claims,
**characterised in that**,
the modulation frequency is selected in a frequency band from 50 to 200 Hz and/or the amplitudes of the modulation are less than 10% of the absolute voltage of the DC voltage portion of the DC voltage converter (5), and/or the DC voltage portion of the output voltage of the DC voltage converter (5) is selected as a function of the charge state of the battery (2).

5. Method according to any one of the preceding claims,
**characterised in that**,
the check takes place cyclically or continually or is triggered based on a triggering event.

6. Method according to claim 5,
**characterised in that**,
a starting of the motor vehicle (12) and/or the detection of a critical operating situation of the low-voltage network (1) is used as a triggering event.

7. Method according to claim 6,
**characterised in that**,
a critical operating situation is detected at least when at least one predetermined, in particular safety-relevant consuming unit (4) can no longer be supplied solely by the DC voltage converter (5) from the high-voltage network (6).

8. Method according to any one of the preceding claims,
**characterised in that**,
in the event a connection fault is detected, corresponding information can be output to the driver of the motor vehicle (12).

9. Method according to any one of the preceding claims,
**characterised in that**,
a resistance measurement is also conducted on the DC voltage converter (5) and its connection to the low-voltage network (1) is checked.

10. Motor vehicle (12), comprising a low-voltage network (1), a high-voltage network (6), the voltage of which is greater than that of the low-voltage network (1), a battery (2) supplying the low-voltage network (1), a DC voltage converter (5) connecting the high-voltage network (6) to the low-voltage network (1), which is configured for exchanging electrical power between the high-voltage network (6) and the low-voltage network (1), and at least one control unit (9, 10) which is configured for carrying out a method according to any one of the preceding claims.

## Revendications

1. Procédé de vérification d'une connexion entre une batterie (2) alimentant un réseau basse tension (1) d'un véhicule automobile (12), dont la tension est plus faible que la tension d'un réseau haute tension (6) du véhicule automobile (12) et le réseau basse tension (1), dans lequel un convertisseur continu-continu (5) qui est réalisé pour l'échange d'énergie électrique entre le réseau haute tension (6) et le réseau basse tension (1), connecte le réseau haute tension (6) au réseau basse tension (1),
**caractérisé en ce**
**que** du côté du convertisseur continu-continu (5) une modulation de la tension de départ est effectuée dans le réseau basse tension avec une fréquence de modulation, dans lequel le courant ainsi appliqué et la tension ainsi appliquée sont mesurés du côté de la batterie (2) et à partir de la tension mesurée et du courant mesuré une valeur de résistance est déterminée et est évaluée par rapport à au moins un critère de connexion, après quoi pour au moins un critère de connexion non rempli un défaut de connexion est constaté.

2. Procédé selon la revendication 1,
**caractérisé en ce**
**que** comme critère de connexion il est vérifié si la résistance se trouve sous une valeur seuil de résistance, en particulier dans la plage de 25 à 50 mohms et/ou si une valeur d'oscillation dérivée de l'évolution temporelle de la résistance se trouve sous une valeur seuil d'oscillation.

3. Procédé selon la revendication 1 ou 2,
**caractérisé en ce**
**que** plusieurs fréquences de modulation sont utilisées simultanément et/ou dans un ordre chronologique et/ou la modulation est effectuée de manière sinusoïdale.

4. Procédé selon l'une quelconque des revendications précédentes,
**caractérisé en ce**
**que** la fréquence de modulation est choisie dans une bande de fréquence de 50 à 200 Hz et/ou l'amplitude de la modulation est inférieure à 10 % de la tension absolue de la part de tension continue du convertisseur continu-continu (5) et/ou la part de tension continue de la tension de départ du convertisseur continu-continu (5) est choisie en fonction de l'état de charge de la batterie (2).

5. Procédé selon l'une quelconque des revendications précédentes,
**caractérisé en ce**
**que** la vérification est effectuée de manière cyclique ou continue ou est déclenchée en raison d'un événement déclencheur.

6. Procédé selon la revendication 5,
**caractérisé en ce**
**qu'**en tant qu'événement déclencheur un démarrage du véhicule automobile (12) et/ou la détection d'une situation de fonctionnement critique du réseau basse tension (1) est utilisée.

7. Procédé selon la revendication 6,
**caractérisé en ce**
**qu'**une situation de fonctionnement critique est détectée au moins si au moins un consommateur (4) prédéterminé, en particulier important pour la sécurité ne pourrait être plus alimenté seulement par le convertisseur continu-continu (5) du réseau haute tension (6).

8. Procédé selon l'une quelconque des revendications précédentes,
**caractérisé en ce**
**qu'**en cas de défaut de connexion constaté une information correspondante est émise à l'attention du conducteur du véhicule automobile (12).

9. Procédé selon l'une quelconque des revendications précédentes,
**caractérisé en ce**
**qu'**aussi sur le convertisseur continu-continu (5) une mesure de résistance est réalisée et sa connexion au réseau de tension faible (1) est vérifiée.

10. Véhicule automobile (12), comprenant un réseau basse tension (1), un réseau haute tension (6), dont la tension est supérieure à celle du réseau basse tension (1), une batterie (2) alimentant le réseau basse tension (1), un convertisseur continu-continu (5) connectant le réseau haute tension (6) au réseau basse tension (1) qui est réalisé pour l'échange d'énergie électrique entre le réseau haute tension (6) et le réseau basse tension (1), et au moins un appareil de commande (9, 10) qui est réalisé pour la réalisation d'un procédé selon l'une quelconque des revendications précédentes.
